Europäisches Patentamt

European Patent Office

Office européen des brevets

(19)

(11) Publication number: **0 124 434**
A 1

# EUROPEAN PATENT APPLICATION

(21) Application number: 84400828.4

(22) Date of filing: 25.04.84

(51) Int. Cl.³: **G 06 M 3/06**, G 01 R 11/24, G 01 F 15/06

(30) Priority: 29.04.83 US 489896
29.04.83 US 489895

(43) Date of publication of application: 07.11.84
Bulletin 84/45

(84) Designated Contracting States: **DE FR GB IT NL**

(71) Applicant: **SANGAMO WESTON, INC., 180 Technology Drive, Norcross Georgia 30092 (US)**

(72) Inventor: **McAuliff, Dan, 512 Hillandale Road, Seneca South Carolina 29678 (US)**
Inventor: **Rilling, John, 7175 Cherry Bluff Drive, Atlanta Georgia 30360 (US)**

(74) Representative: **Chareyron, Lucien et al, Schlumberger Limited Service Brevets c/o Giers, B.P. 121 12, place des Etats-Unis, F-92124 Montrouge Cedex (FR)**

(54) Optically encoded information display apparatus with tampering indicator.

(57) A display register for displaying information which may vary over time has optically readable code markings associated with the display positions of the register. The optically readable code markings are, for example, bar codes which correspond to the value of the information being displayed by the register. In one version of the invention the bar codes are applied using visible ink adjacent to or over human perceivable markings on the display register. A hand-held laser scanning device is used to read the code markings. Alternatively, the bar codes are applied using an ultraviolet sensitive ink (which is otherwise invisible to the naked eye) directly over the human perceivable markings on the register. The bar codes are then scanned using a UV laser device. In addition to encoding the variable information displayed by the display register, fixed information, such as the serial number of the display register, location, manufacturer, etc., can be encoded on the face of the register and scanned by the scanning device. The display register may also have an auxiliary display position which will display a code indicative of tampering with the display register. The invention finds particular utility in the remote reading of billing meters, such as those used to measure the consumption of water, natural gas, or electricity.

SCANNING & DATA STORAGE ELECTRONICS

OPTICALLY ENCODED INFORMATION DISPLAY APPARATUS

WITH TAMPERING INDICATOR

Background of the Invention

Field of the Invention

The invention relates to the field of remotely readable display registers, and more particularly to a display register and a tampering indicator which are optically encoded so as to be remotely readable by optical scanning apparatus.

Description of the Prior Art

Display registers of many types are used in a wide variety of devices to display a measured quantity. For example, gas, water and electric utilities use display registers to show how much of their commodity has been used by a consumer.

The types of displays used by utilities fall into two broad categories: (1) cyclometer-type registers, which are similar to the odometer in an automobile, and (2) clock-type registers, in which each decimal unit of a measured quantity is indicated on a clock-like dial having ten digits (0-9) and a single indicating hand.

Both types of displays are mechanical in nature. The cyclometer register consists of one or more drums having their rotational axes horizontally aligned with each other. Each such drum or display element has one or more display positions bearing, for example, an alphanumeric character such as the numerals 0-9. The cyclometer drums are driven by a clock-like escapement mechanism or a solenoid which is responsive to a measuring device for measuring the quantity of the particular commodity being consumed. The dial-type display register is driven in a similar fashion with the visible display elements being a separate clock dial and pointer for each decade of the display.

Typically, utilities monitor the consumption of their commodity on a monthly basis. This entails having a meter reader visit each customer's location and physically read the quantity being displayed on the display register. In addition to reading the measured quantity, the meter reader must also make a note of which meter location he is reading so that the proper customer will be billed. It will be appreciated that the reading of utility meters is subject to error since it relies upon human inspection and interpretation. Further, even if the information from the meter (e.g. quantity and location) is properly noted the information may be improperly transcribed at the utility's data processing center resulting in an incorrect bill being rendered to the customer.

Various schemes have been devised in order to automate the meter reading process. Most of these rely upon some type of electronic encoding of the display register positions inside the utility meter. However, this approach requires specialized electronic circuitry built into the meter along with some sort of interface to the power line (if power line carrier meter polling is used) or some sort of radio frequency transponder (if remote radio polling is used). Obviously, the inclusion of additional electronics into the utility meter increases its cost and thus makes such remote meter reading schemes relatively uneconomical. In addition, the electronics must have a source of power which is reliable. In the case of electrical metering power can be derived directly from the metering circuit. However, such electronics must be able to withstand extremely high transient voltages and currents and be stable over a wide range of temperatures and have a useful life approximating that of the typical electro-mechanical watthour meter (in excess of twenty years).

In the case of gas and water metering there is no ready source of power for such electronic circuits. Battery power is unreliable and requires periodic inspection and replacement of the batteries. For these reasons gas and water utilities generally have been unwilling to consider remote reading devices for consumer applications.

00124434

In addition to the task of recording the amount of commodity consumed and the location of the utility meter, the meter reader generally will also make a cursory inspection of the meter to see if it has been tampered with. Various mechanical and electronic anti-tampering devices, including lead seals connecting the cover of the meter with its base and warning flags or lights, have been developed to indicate if a utility meter has been tampered with. However, all of these devices require inspection and interpretation by the meter reader to be effective.

It would therefore be of great benefit to the utility metering industry if there were developed a system for remotely reading a utility meter's display register such that errors due to human interpretation were eliminated, while not requiring any extensive modifications to the utility meter or the addition of any electronic devices requiring auxiliary power. Further, it would be advantageous if such remote meter reading were accomplished in such a manner that the reading of the display register is automatically converted into digital form and stored so that errors in transcription prior to computing a customer's bill are prevented.

## Summary of the Invention

One aspect of the present invention is directed to an information display apparatus of the type including at least one display element having at least one display position for displaying information which may vary over time, including code markings associated with at least one display position of each display element and readable by optical reading means remote from the display apparatus.

Another aspect of the present invention is directed to an information display apparatus of the type including at least one display element having at least one display position for displaying information which may vary over time, including code markings associated with at least one display position of each display element and readable by optical reading means remote from the display apparatus, and wherein the code markings associated with one of said display positions are indicative of tampering with the information display apparatus, and further including: means for detecting said tampering; and control means responsive to said detecting means for displaying the display position associated with the tampering indicating code markings.

The optical reading means may include a source of radiation, means for scanning the code markings with the radiation, and means for detecting radiation scattered from the code markings. The source of radiation, for example, comprises a laser beam.

In addition to code markings associated with the variable display of information and for indicating tampering, further code markings can be provided for displaying fixed information, e.g. display apparatus serial number, location, manufacturer's name, etc.

While it is recognized that bar codes and optical readers therefor are well-known, heretofore such code markings have always been of a fixed nature, e.g. printed labels bearing a fixed and unchangeable set of code markings representative of a product code, manufacturer's name or other such static information. Applicants, however, have recognized that the benefits of remote scanning can be brought to registers which display information which may vary over time and for indicating tampering with such registers.

Advantageously, the described invention enables an optical scanning device such as a commercially available bar code scanner, which is remote from and not connected to the information display apparatus to be used to read code markings on the information display indicative of both variable information (e.g. for a utility meter, the amount of gas, water or electricity which has been consumed) and any fixed information, such as the serial number of the display apparatus being read. Information can be read quickly and accurately by the scanning device without the need for extensive mechanical or electronic modification of the display. Further advantages are that the information read by the optical scanning device is stored as digital data, and the fixed information indicative of the serial number and/or location of the display register is associated with the variable information indicative of the quantity of a commodity which is measured by the meter. In this manner, errors both in reading the meter register itself and in transcribing the data are eliminated.

Further, if the meter is in any way tampered with a tamper indicating code marking is arranged to appear at a display position in the register. The optical reading device can be arranged to give an alarm indication if such a tamper indicating code marking is read.

The present invention is applicable not only to cyclometer-type and clock dial-type display registers but also is adaptable to electronic displays. For example, a liquid crystal display can be arranged to display not only alphanumeric (e.g. human perceivable) characters but also to display code markings (e.g. bar code) which are readable by a remote optical reader. The code markings can be arranged to be generated simultaneously with the human perceivable markings, or alternately with the human perceivable markings, or just by themselves. Such an arrangement would be useful with any electronic display, but especially where the electronic display has no provision for transmitting data to a separate location.

The present invention finds utility not only in the remote reading of billable commodities such as gas, water and electricity but also to the remote reading of virtually any type of information display such as automobile or truck odometers, elapsed time meters, digital displays, etc.

Brief Description of the Drawing Figures:

These and other features and advantages of the present invention will be readily understood with reference to the following detailed description of the preferred embodiments when taken in conjunction with the accompanying drawing figures wherein:

Fig. 1 shows the overall arrangement of a system for scanning and reading code markings on a display register in accordance with the present invention;

Fig. 2 shows a first type of display register and associated optically readable code markings;

Fig. 3 shows a alternative version of the display register of Fig. 2;

Fig. 4 shows a second type of display register and associated optically readable code markings;

Fig. 5 shows the details of one type of tamper indicating device for use with the registers of Figs. 2, 3 or 4; and

Fig. 6 is a chart showing one type of code markings which can be used with the present invention.

Detailed Description of the Preferred Embodiments

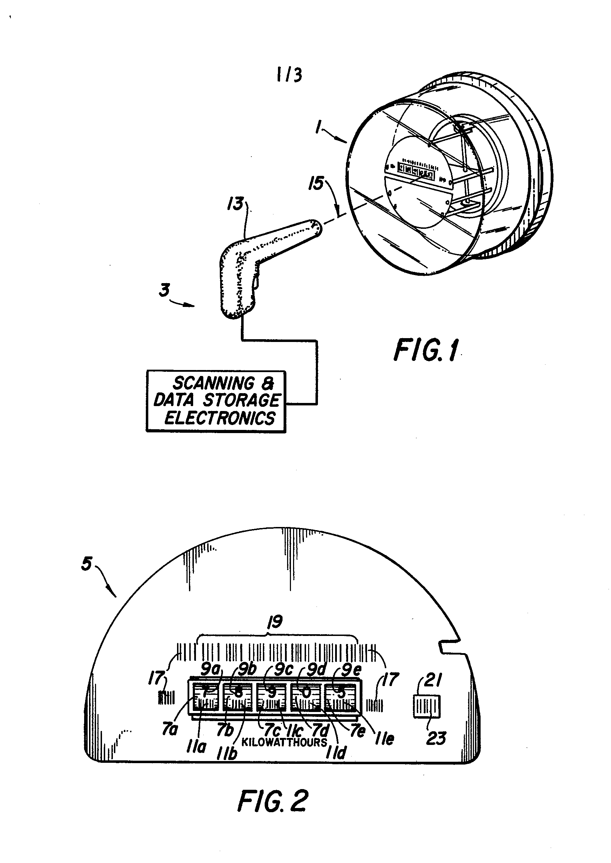

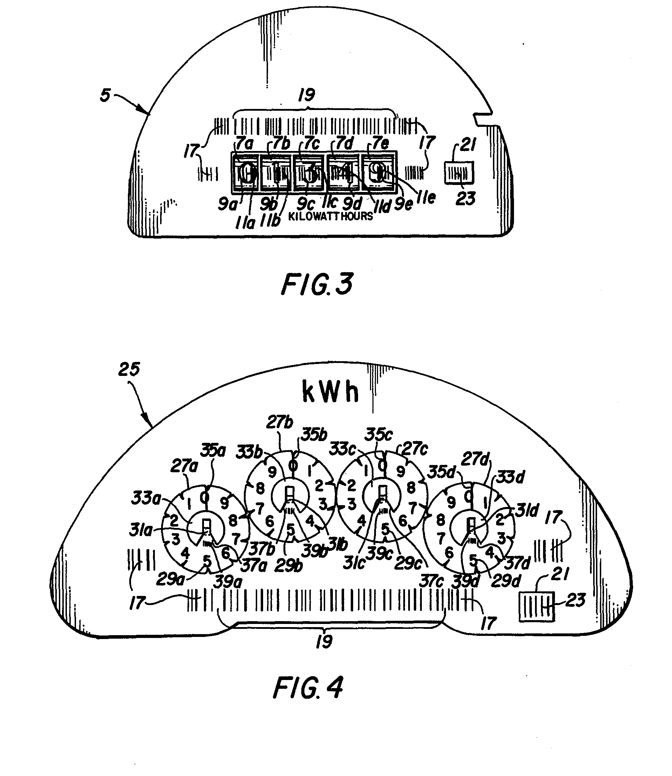

Fig. 1 shows the overall arrangement of a typical information display apparatus 1 which is remotely readable by an optical reading device, shown generally at 3. Display apparatus 1 is, for example, a utility billing meter such as a watthour meter. Such types of utility meters often use a cyclometer-type display mechanism (similar to the odometer in an automobile) to display a measured quantity, e.g. electrical power consumption. Such cyclometer-type display registers are well-known and are shown for example in U.S. Pat. No. 3,428,895. A second type of display register, called the clock dial-type is also commonly used. This type of register is shown in Fig. 4 and its construction is well-known as exemplified by U.S. Pat. Nos. 4,083,000 and 3,700,839.

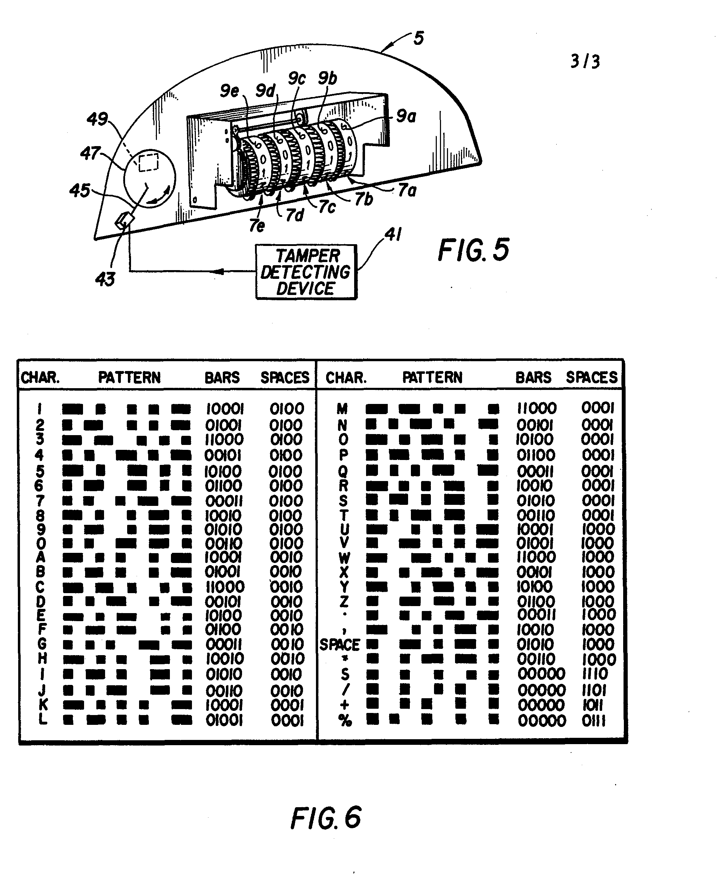

In a first embodiment of the invention display apparatus 1 comprises a cyclometer-type display register 5, as shown in Fig. 2. Display register 5 includes one or more display elements 7a-7e each having one or more display positions 9a-9e, respectively, formed thereon. Each display element comprises a cylindrical drum whose rotational axis is aligned horizontally with neighboring display elements. The one or more display positions 9 on each display element can be, for example, a human perceivable symbol such as a alphanumeric character. See also Fig. 5.

Associated with each display position 9a-9e is a code marking 11a-11e corresponding to the human perceivable markings being displayed. As shown in Fig. 2, these code markings are, for example, a bar code which is placed immediately adjacent the human perceivable markings at the display positions 9a-9e. It will thus be appreciated as the various human perceivable markings (such as the numerals 0-9) of each display element are brought into view, the code marking associated with the particular display position will also be brought into view. Thus, as the information being displayed by register 5 changes, such as occurs when the register is used to indicate the value of a measured quantity which can change over time, the particular code markings corresponding to the measured quantity will be brought into view.

Bar codes are a well-known type of data encoding. Bar codes come in a number of varieties, with one common code called Code 39 (or 3 of 9). Each character is represented by 9 elements (5 bars and 4 spaces). Three of the 9 elements are wide (binary value 1) and six elements are narrow (binary value 0). Spaces between characters (inter-character gaps) have no code value. Code 39 is a variable length code and is self-checking. Code 39 is also bi-directional which allows scanning in either direction. A unique stop/start character is used to indicate the beginning point and ending point of encoded information. See Fig. 6.

When code markings of the bar code type are scanned by a source of radiation the radiation scattered by the varying light and dark bars is detected as a series of variable length pulses by a photosensitive detector in the optical reading device 13. These encoded data pulses are then stored or transmitted for further processing.

The code markings displayed by register 5 can then be remotely read by the optical reading device 3, as shown in Fig. 1. Optical reading device 3 is a commercially available optical scanner such as sold by Symbol Technologies, Inc., Hauppage, New York as their Laser Scan LS-7000 Handheld Scanning System. This optical reading device is exemplary of the types of reading devices useful with the present invention and includes a handheld unit having a source of radiation, such as a laser, a scanning device, such as a rotating mirror, and a photodetector for detecting radiation scattered from code markings scanned by a beam 15 produced by the radiation source and emitted from the scanning unit 13.

This type of laser scanning bar code reader has the advantage that an operator need not physically sweep the beam of radiation across the code markings. The scanning apparatus automatically 0012443 4 sweeps the laser beam across a wide area a large number of times insuring that all code markings are scanned and detected. Also, the optical system of the photodetector can be arranged to have a relatively wide depth of field, thus allowing the scanning device to be held at various distances from the code markings on the register without affecting the accuracy of scanning or reading.

In addition to the varying code markings 11, register 5 can also be provided with one or more fixed code markings, such as stop/start characters 17 and one or more code markings 19 indicative of the display apparatus' serial number, manufacturer, location, type, etc. An auxiliary display element 21 can also be provided for giving an indication if the display apparatus has been tampered with, as is described in more detail below. A unique code marking 23 is provided for display element 21 to indicate such tampering.

It will thus be appreciated that the use of an optical reading device 3 to read code markings on a display apparatus such as register 5 enables both the fixed and variable information on the register to be quickly and accurately read and converted into a form suitable for subsequent data processing. Such a system is eminently suitable for the reading of utility billing meters, such as gas, water or electric meters in which the amount of a commodity consumed by a user must be accurately and quickly read, while requiring no more than a minor modification to the display register. In addition, no expensive internal electronics or auxiliary power are necessary. This makes the present invention suitable for use in environments, such as gas or water metering, where electrical power is unavailable or unsuitable. The present invention also has the advantage that the data acquired by the optical reading device is already in a form suitable for subsequent data processing, thus making transcription errors, which heretofor have been associated with transcribing hand written meter readings taken by a meter reader, impossible. Thus a utility customer will not be inadvertantly overcharged nor will the utility lose revenue through errors in reading the customer's meter. In addition, where a customer site number or meter serial number is provided as part of the code markings on the meter register, it is an easy task for the utility's data processing equipment to matchup these serial numbers or site numbers with a list of those serial numbers or site numbers which should have been read to insure that the meter reader has visited all customer sites and read their meters. The reading device 3 can also be arranged to emit an audible or visible alarm if a tamper-indicating code marking 23 is detected. This immediately alerts the meter reader to the fact that the meter possibly has been tampered with so that appropriate action can be taken.

Fig. 3 shows an alternative version of the optically encoded display register 5. Display elements 7a-7e and associated display positions 9a-9e are similar to those described with respect to Fig. 2. Fixed code markings 17 and 19 and tamper-indicating markings 23 are also similar to that shown in Fig. 2. However, the code markings 11a-11e, 17, 19 and 23 are applied using an ink, such as a phosphorescent ink, which is normally invisible to the naked eye but which can be scanned and detected by reading device 3 through the use of a radiation source to which the ink is sensitive. Thus, for example, an ultraviolet light source, such as a near-UV laser can be used to scan the bar code markings on register 5. The use of a normally invisible ink has the advantage that it can be directly applied over other human perceivable figures without interfering with either the interpretation of the figures by a meter reader or by the reading device 3. There is therefore no need to modify the size of the human perceivable characters provided on display elements 7a-7e, thus enabling them to be readily viewed by the customer or, in the event the reading device is broken, the meter reader. It is also especially advantageous if the tamper-indicating code markings 23 are applied using an invisible ink so that an individual who tampers with the meter will not be warned that his tampering has been detected and thereby not be compelled to attempt to subvert the tamper-indicating device. It will be appreciated that other types of inks sensitive to various wavelengths of radiation can be substituted for the UV sensitive ink. In one embodiment, the code markings may be applied over human perceivable markings in a different colour visible to the human eye.

00124434

In yet another version of the invention shown in Fig. 4, the concept of encoding a register displaying information which varies over time is extended to a clock dial-type register, such as commonly used in the United States to meter natural gas and electrical power consumption. As mentioned earlier, the construction and operation of clock dial-type registers are well-known. Clock dial register 25 includes a number of circular display elements 27a-27d each having one or more display positions 29a-29d bearing some form of human readable markings, such as the numerals 0-9. Associated with each display element 27a-27d is a respective shaft 31a-31d, the shafts being interconnected with each other by a clockwork mechanism (not shown) of a design well-known in the art. Each such shaft has associated therewith a pointer and shield arrangement 33a-33d, respectively. Each such pointer and shield arrangement includes a respective pointer 35a-35d which is used to visually indicate the value of a measured quantity. Opposite to each pointer 35a-35d there is provided a cutout sector or opening 37a-37d, respectively. This cutout exposes a code marking, such as a bar code, which corresponds to the value or quantity to which its associated pointer 35a-35d is indicating.

It will thus be appreciated that as register shafts 31a-31d rotate and move the pointer and shield arrangements 33a-33d to thereby indicate the value of a measured quantity, the appropriate code markings associated with the measured value will be exposed by cutout sectors 37a-37d. These code markings are then scanned using a optical reading device 3 as described above. Register 25 may further include fixed markings such as stop/start markings 17, a serial number/site number/manufacturer code marking 19 and a tamper-indicating display position 21 displaying a tamper-indicating code marking 23, all similar to those described above with respect to Figs. 2 and 3.

It will be appreciated that in addition to the above types of displays, that the concept of the present invention can be readily extended to electronic type alphanumeric displays. For example, a liquid crystal display can be provided with appropriate code marking elements to be driven by the display circuitry for displaying, for example, a bar code representation of the 0124434 characters being displayed at each display position. Such a display can be scanned using a reading device 3 as described above. The electronic display can be arranged to display the human perceivable (e.g. alphanumeric) characters and code markings simultaneously, alternately, or only to show the code markings. This arrangement enables an optical reader of the type described above to remotely read out the values of such an electronic display without the necessity of any communications interface or transmitting circuitry associated with the display apparatus.

As mentioned above, the concepts of the present invention can be used to give an indication that the display apparatus has been tampered with in a manner such that the optical reading device 3 will automatically detect such tampering and alert the operator.

Various types of anti-tampering and tamper-warning indicators are known. Most such anti-tampering schemes rely upon some sort of physical security such as a wire loop joined by a lead seal which holds the cover of a watthour meter to its permanently mounted base. Electronic anti-tampering devices detect the removal of the cover from a utility meter or, in the case of an electricity meter, the removal of the entire meter from its socket and are generally arranged to give a visual indication that such removal or tampering has occurred. Such tamper detecting devices are shown in U.S. Patents 4,386,313 and 4,386,314 both issued on May 31, 1983 and assigned to the assignee of the present invention. In both of these patents, the removal of a utility meter, such as an electricity meter, causes one of its mounting connections (e.g. a power conducting bayonet) to be pulled out of its normal position and to thereby actuate a tamper-indicating circuit. Such tamper-indicating means can be readily adapted for use in the present invention as shown in Fig. 5.

A tamper detecting device 41, as discussed above, produces a tamper-indicating signal which is then applied to actuating means, for example a latching solenoid 43 having an arm 45 connected off-center to a pivoting disk 47 which in turn is mounted immediately behind a display window 49. Disk 47 and window 49 together constitute the tamper display position 21 referred to above with respect to Figs. 2, 3 and 4. On the side of disk 47 facing window 49 there is printed a unique code marking 23. Disk 47 is arranged such that normally only a blank portion of the disk is exposed through window 49. However if tampering is detected by tamper detecting device 41 a signal is applied to solenoid 43 causing arm 45 to be moved and driving disk 47 in a manner which brings tamper-indicating code markings 23 into view through window 49. These code markings can be made visible to the naked eye or can be applied using invisible ink, as discussed above, such that they are perceivable only by optical reading device 3. Thus, when a meter reader reads the display of registers 5 or 25, if the tamper-indicating code marking 23 is present in window 49 an indication will be given by reading device 3 that the register has been tampered with.

Of course, various other types of schemes could be used to display a tamper-indicating code marking for the display register. Thus, for example, a simple trip-wire connected between the cover and base of the display apparatus could be used to pull a one way pawl which would in turn move a tamper-indicating flag bearing appropriate code markings into view within window 49.

While the present invention has been described in considerable detail, various modifications and changes will occur to those skilled in the art. Accordingly, the foregoing description is intended to be illustrative but not limitative of the invention which is described in the appended claims.

Claims

1. An information display apparatus of the type including at least one display element having at least one display position for displaying information which may vary over time, characterized by: code markings associated with at least one display position of each display element and readable by optical reading means remote from the display apparatus.

2. The apparatus of claim 1 characterized in that the code markings associated with one of said display positions are indicative of tampering with the information display apparatus, and further characterized by: means for detecting said tampering; and control means responsive to said detecting means for displaying the display position associated with the tampering indicating code markings.

3. The apparatus of claim 2 characterized by a housing for the apparatus and characterized in that said tampering detecting means is responsive to tampering with said housing.

4. The apparatus of any one of claims 1-3 further characterized by means remote from the information display for optically reading the code markings.

5. The apparatus of any one of claims 1-4 characterized in that said optically readable code markings comprise a bar code.

6. The apparatus of any one of claims 1-5 characterized in that the optically readable code markings are applied using an ink which is readable by the reading means.

7. The apparatus of claim 6 characterized in that the ink is sensitive to ultraviolet radiation and the reading means includes a source of ultraviolet radiation to read the code markings.

8. The apparatus of claim 4 characterized in that the optical reading means includes a source of radiation, means for scanning the code markings with the radiation, and means for detecting radiation scattered from the code markings.

9. The apparatus of claim 5 characterized in that the source of radiation is a laser.

10. The apparatus of any one of claims 1-9 characterized in that each of the display elements is a cyclometer-type register.

11. The apparatus of any one of claims 1-9 characterized in that each of the display elements is a clock dial-type register.

12. The apparatus of any one of claims 1-9 characterized in that each of the display elements is an electronic display.

13. The apparatus of any one of claims 1-12 characterized in that at least one of the code markings is fixed.

14. The apparatus of any one of claims 1-13 characterized in that the code markings are indicative of alphanumeric characters.

15. The apparatus of any one of claims 1-14 further characterized by human perceivable markings corresponding to the information to be displayed associated with each code marking.

16. The apparatus of claim 6 or claim 7 characterized in that the code markings are applied over human perceivable markings in a different color visible to the human eye, said code markings corresponding to information to be displayed provided at each display position.

1/3

SCANNING &
DATA STORAGE
ELECTRONICS

FIG.1

KILOWATTHOURS

FIG.2

2/3

**FIG.3**

**kWh**

**FIG.4**

FIG. 5

| CHAR. | PATTERN | BARS | SPACES | CHAR. | PATTERN | BARS | SPACES |
|---|---|---|---|---|---|---|---|
| 1 | | 10001 | 0100 | M | | 11000 | 0001 |
| 2 | | 01001 | 0100 | N | | 00101 | 0001 |
| 3 | | 11000 | 0100 | O | | 10100 | 0001 |
| 4 | | 00101 | 0100 | P | | 01100 | 0001 |
| 5 | | 10100 | 0100 | Q | | 00011 | 0001 |
| 6 | | 01100 | 0100 | R | | 10010 | 0001 |
| 7 | | 00011 | 0100 | S | | 01010 | 0001 |
| 8 | | 10010 | 0100 | T | | 00110 | 0001 |
| 9 | | 01010 | 0100 | U | | 10001 | 1000 |
| 0 | | 00110 | 0100 | V | | 01001 | 1000 |
| A | | 10001 | 0010 | W | | 11000 | 1000 |
| B | | 01001 | 0010 | X | | 00101 | 1000 |
| C | | 11000 | 0010 | Y | | 10100 | 1000 |
| D | | 00101 | 0010 | Z | | 01100 | 1000 |
| E | | 10100 | 0010 | . | | 00011 | 1000 |
| F | | 01100 | 0010 | , | | 10010 | 1000 |
| G | | 00011 | 0010 | SPACE | | 01010 | 1000 |
| H | | 10010 | 0010 | * | | 00110 | 1000 |
| I | | 01010 | 0010 | S | | 00000 | 1110 |
| J | | 00110 | 0010 | / | | 00000 | 1101 |
| K | | 10001 | 0001 | + | | 00000 | 1011 |
| L | | 01001 | 0001 | % | | 00000 | 0111 |

FIG. 6

00124434

European Patent
Office

**EUROPEAN SEARCH REPORT**

Application number

EP  84 40 0828

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | GB-A-2 018 069  (GEORGE KENT)<br>* Figure 1; abstract *<br><br>--- | 1 | G 06 M   3/06<br>G 01 R  11/24<br>G 01 F  15/06 |
| A | US-A-4 301 444  (E.J. BRUCKERT et al.)<br>* Abstract *<br><br>----- | 2 | |

**TECHNICAL FIELDS SEARCHED (Int. Cl. ³)**

G 01 F
G 01 R
G 06 M

The present search report has been drawn up for all claims

| Place of search | Date of completion of the search | Examiner |
|---|---|---|
| THE HAGUE | 07-08-1984 | MIELKE W |